# EUROPEAN PATENT APPLICATION

(11) **EP 1 986 219 A1**
(43) Date of publication of application: **29.10.2008**
(21) Application number: 07708229.5
(22) Date of filing: 08.02.2007
(51) Int. Cl.: H01L 21/02, H01L 21/336, H01L 27/12, H01L 29/786

(54) **SOI SUBSTRATE AND METHOD FOR MANUFACTURING SOI SUBSTRATE**

(30) Priority: 15.02.2006 JP 2006037771
(71) Applicant: Shin-Etsu Chemical Co., Ltd., Tokyo 100-0005 (JP)
(72) Inventor: AKIYAMA, Shoji, Annaka-shi, Gunma 379-0195 (JP); KUBOTA, Yoshihiro, Annaka-shi, Gunma 379-0195 (JP); ITO, Atsuo, Annaka-shi, Gunma 379-0195 (JP); TANAKA, Koichi, Annaka-shi, Gunma 379-0195 (JP); KAWAI, Makoto, Annaka-shi, Gunma 379-0195 (JP); TOBISAKA, Yuuji, Annaka-shi, Gunma 379-0195 (JP)
(74) Representative: HOFFMANN EITLE
(86) International application number: PCT/JP2007/052236
(87) International publication number: WO 2007/094233

(57) **Abstract**

An oxide film (11) having a thickness "tₒₓ" of not less than 0.2 µm is provided on the bonding surface of a single-crystal silicon substrate (10). In a method for manufacturing an SOI substrate according to the present invention, a low-temperature process is employed to suppress the occurrence of thermal strain attributable to a difference in the coefficient of thermal expansion between the silicon substrate (10) and a quartz substrate (20). To this end, the thickness "tₒₓ" of the oxide film (11) is set to a large value of not less than 0.2 µm to provide sufficient mechanical strength to the thin film to be separated and, at the same time, to allow strain to be absorbed in and relaxed by the relatively thick oxide film to suppress the occurrence of transfer defects during the step of separation.

## Description

### Technical Field

The present invention relates to an SOI substrate having a single-crystal silicon thin film on a quartz substrate which is a transparent insulating substrate and to a method for manufacturing the SOI substrate.

### Background Art

An SOQ (silicon-on-quartz) substrate having a silicon thin film on a quartz substrate is an SOI substrate which is expected to be applied to optical devices, for example, devices for the manufacture of TFT liquid crystal monitors. In order to obtain such an SOQ substrate as described above, there is proposed a method for forming a silicon thin film on a quartz substrate by bonding together substrates of different material types, i.e., an SOI layer-forming silicon substrate and a handling substrate which is the quartz substrate.

Conventionally, as a method for manufacturing an SOI substrate by bonding together two substrates, there is known the SmartCut method in which a silicon substrate, on the bonding surface side of which hydrogen ions have been implanted, and a handling substrate are bonded together and subjected to a heat treatment at a temperature of approximately 500°C or higher. Then, a silicon thin film is thermally peeled off from a region where the concentration of the implanted hydrogen ions is highest (see, for example, Japanese Patent No. 3048201 (patent document 1) and A. J. Auberton-Herve et al., "SMART CUT TECHNOLOGY: INDUSTRIAL STATUS of SOI WAFER PRODUCTION and NEW MATERIAL DEVELOPMENTS" (Electrochemical Society Proceedings Volume 99-3 (1999) pp. 93-106) (non-patent document 1)). This method is based on a mechanism in which high-density "gas bubbles" formed by implanting hydrogen ions and called a "microbubble layer" are "grown" by heating, thereby peeling off a silicon thin film by taking advantage of this "bubble growth".

According to a study made by the present inventor et al., however, it has become evident that the yield easily degrades noticeably in a step of silicon thin film separation performed in succession to the bonding together of a silicon substrate and a quartz substrate if an attempt is made to fabricate an SOQ substrate using the above-described SmartCut method or a method similar to this method. The present inventor et al. have the understanding described below as to the cause for this yield degradation.

Since the SmartCut method is designed to "grow" high-density "gas bubbles" formed by implanting hydrogen ions and called a "microbubble layer" by heating to peel off a silicon thin film by taking advantage of this "bubble growth", the method requires a heat treatment at a relatively high temperature of approximately 500°C or higher in a separation step.

On the other hand, if a high-temperature heat treatment is applied to substrates, such as a silicon substrate and a quartz substrate, having different thermal expansion coefficients, with the substrates bonded together, a thermal strain due to a difference in thermal expansion coefficient between the two substrates is generated. This thermal strain makes the separation or the crack of bonding surfaces or the like easy to occur. Accordingly, it is desirable to complete silicon thin film separation using a relatively low-temperature process.

In general, however, a relatively high-temperature heat treatment needs to be applied with the two substrates bonded together, in order to ensure an excellent bonding state and an sufficient bonding strength across the entire bonded surfaces of the silicon substrate and the quartz substrate.

That is, when fabricating an SOQ substrate by bonding together a silicon substrate and a quartz substrate, there arises a mutually exclusive relationship between a demand for a shift toward low-temperature processes required to avoid the separation or the crack of the bonding surfaces or the like due to a thermal strain caused by a difference in thermal expansion coefficient between the two substrates and a relatively high-temperature heat treatment necessary to ensure an excellent bonding state across the entire bonded surfaces.

If an attempt is made to fabricate the SOQ substrate using a low-temperature process, regions in which the bonding strength of the bonding surfaces of the silicon substrate and the quartz substrate is insufficient are more likely to arise locally. In these regions, transfer defects, slip dislocation or the like tends to occur in a separation step.

Note that a study has also been made of a method for manufacturing an SOI wafer adapted to prevent the occurrence of thermal strain, separation, cracks and the like attributable to a difference in thermal expansion coefficient between substrates to be bonded together (see, for example, Japanese Patent Laid-Open No. 11-145438 (patent document 2)). However, the technique disclosed in patent document 2 also requires a heat treatment at 350 to 450°C for the "full bonding" of a single-crystal silicon substrate and an insulating substrate such as a quartz substrate. Therefore, it cannot be said, from the viewpoint of an SOQ substrate manufacturing process, that a full shift toward low-temperature processes has been realized.

The present invention has been accomplished in view of the above-described problems. It is therefore an object of the present invention to provide a technique to avoid causing any transfer defects or slip dislocation in a subsequent separation step even when the bonding together of a single-crystal silicon substrate and a quartz substrate is performed using a low-temperature process, thereby increasing a yield in a step of silicon thin film separation and improving the surface condition of an SOI layer obtained by separation.

### Disclosure of the Invention

In order to solve the above-described problems, an SOI substrate according to a first aspect of the present invention is such that an SOI layer formed of a silicon thin film bonded through a silicon dioxide film having a thickness of not less than 0.2 µm is provided on a quartz substrate which is a transparent insulating substrate.

In addition, an SOI substrate according to a second aspect of the present invention is such that an SOI layer formed of a silicon thin film bonded through a silicon dioxide film is provided on a quartz substrate which is a transparent insulating substrate and the thickness of the oxide film is equal to or greater than twice the thickness of the SOI layer.

In these SOI substrates of the present invention, the oxide film can be a thermally-oxidized film of the single-crystal silicon substrate, and a substrate on the bonding surface side of which embedded patterns are provided can be used as the quartz substrate.

A first method for manufacturing an SOI substrate according to the present invention includes:
a first step of forming a silicon dioxide film having a thickness of not less than 0.2 µm on a surface of a first substrate which is a single-crystal silicon substrate;
a second step of forming an ion-implanted layer in the first substrate by implanting hydrogen ions therein through the oxide film;
a third step of applying a surface activation treatment to the bonding surface of at least one of the second substrate which is a quartz substrate and the first substrate;
a fourth step of bonding together the surface of the first substrate and the surface of the second substrate; and
a fifth step of forming an SOI layer on the surface of the second substrate by peeling off a silicon thin film from the first substrate of the bonded substrate provided after the heat treatment.

In addition, a second method for manufacturing an SOI substrate according to the present invention includes:
a first step of forming a silicon dioxide film having a thickness of "tₒₓ" on a surface of a first substrate which is a single-crystal silicon substrate;
a second step of forming an ion-implanted layer having an average ion implantation depth L equal to or less than half the thickness of the oxide film (2L ≤ tₒₓ) in the first substrate by implanting hydrogen ions therein through the oxide film;
a third step of applying a surface activation treatment to the bonding surface of at least one of the second substrate which is a quartz substrate and the first substrate;
a fourth step of bonding together the surface of the first substrate and the surface of the second substrate; and
a fifth step of forming an SOI layer on the surface of the second substrate by peeling off a silicon thin film from the first substrate of the bonded substrate provided after the heat treatment.

In these manufacturing methods, the third step of surface activation treatment is preferably carried out by means of at least one of plasma treatment and ozone treatment.

In addition, the fourth step may include a sub-step of heat-treating the first substrate and the second substrate at 100 to 300°C after the bonding together, with the substrates bonded together.

Furthermore, the first step of oxide film formation may be carried out by thermally oxidizing the surface of the single-crystal silicon substrate. In addition, the third step may include a sub-step of previously forming embedded patterns on the bonding surface side of the quartz substrate.

In the present invention, the thickness of the silicon dioxide film provided on the single-crystal silicon substrate and the correlation between the thickness of the silicon dioxide film and the depth of formation of the ion-implanted layer have been optimized. Consequently, it is possible to prevent any transfer defects or slip dislocation from occurring in a subsequent separation step, even if the single-crystal silicon substrate is bonded to the quartz substrate without applying such a relatively high-temperature heat treatment as used in conventional methods. As a result, it is possible to increase a yield in a step of silicon thin film separation and improve the surface condition of an SOI layer obtained by separation.

### Brief Description of the Drawings

Figure 1(A) is a cross-sectional view used to explain a general condition of the bonding surface of a single-crystal silicon substrate used in a method for manufacturing an SOI substrate of the present invention, and Figure 1(B) is a schematic cross-sectional view of an SOQ substrate having an SOI layer obtained by separation;
Figures 2(A) to 2(C) are conceptual cross-sectional views used to explain the surface conditions of quartz substrates to be bonded to single-crystal silicon substrates, wherein Figure 2(A) illustrates a case that a quartz substrate has microscopic roughness, Figure 2(B) illustrates a case that microparticles adhere to the bonding surface of a quartz substrate, and Figure 2(C) illustrates a case that there is surface irregularity reflecting embedded patterns previously provided in the bonding surface region of a quartz substrate;
Figure 3 is a schematic view used to conceptually explain a way a defect occurs in a step of fabricating an SOQ substrate by peeling off a silicon thin film from a single-crystal silicon substrate;
Figure 4 is a schematic view used to explain a process example of a method for manufacturing an SOI substrate according to the present invention; and
Figure 5 is a conceptual schematic view used to explain various techniques for peeling off a silicon thin film.

### Best Mode for Carrying Out the Invention

Hereinafter, the best mode for carrying out the present invention will be described with reference to the accompanying drawings.

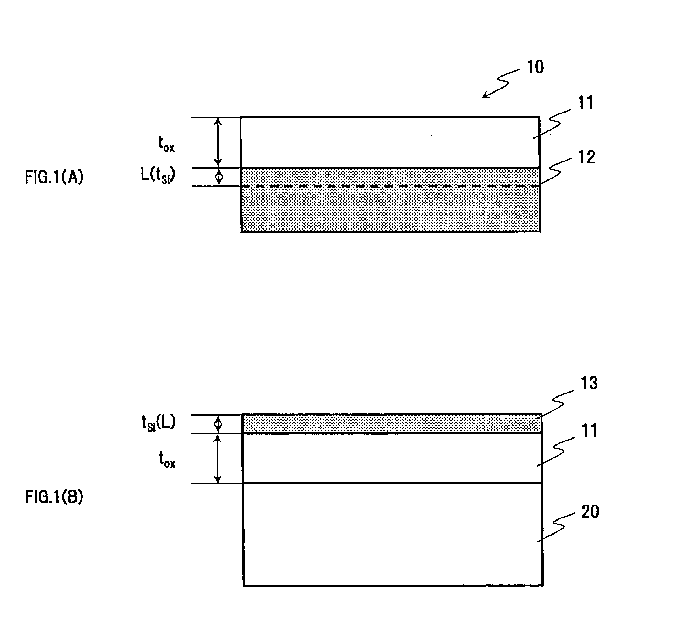

Figure 1(A) is a cross-sectional view used to explain a general condition of the bonding surface of a single-crystal silicon substrate used in a method for manufacturing an SOI substrate of the present invention, and Figure 1(B) is a schematic cross-sectional view of an SOQ substrate having an SOI layer obtained by separation.

As illustrated in Figure 1(A), a silicon dioxide film 11 having a thickness of "tₒₓ" is provided on one principal surface (bonding surface) of a single-crystal silicon substrate 10, and a hydrogen ion-implanted layer 12 is formed near the substrate surface at an average ion implantation depth L. The oxide film 11 is a film obtained by, for example, thermally oxidizing a surface of the single-crystal silicon substrate 10, and the ion-implanted layer 12 is formed by implanting hydrogen ions at a dose amount on the order of 10¹⁶ to 10¹⁷ atoms/cm². Note that the average ion implantation depth L of the ion-implanted layer 12 is generally defined as 0.05 to 0.3 µm.

In the present invention, the thickness "tₒₓ" of the oxide film 11 is set to not less than 0.2 µm, in order to prevent any transfer defects or slip dislocation from occurring during a step of silicon thin film separation after the single-crystal silicon substrate is bonded to the quartz substrate.

In the separation step, the separation of a silicon thin film takes place in a position at an average ion implantation depth L shown by reference numeral 12 in Figure 1(A) after the single-crystal silicon substrate and the quartz substrate are bonded together. This silicon thin film is transferred onto the quartz substrate 20 through the oxide film 11 to become the SOI layer 13 (Figure 1(B)).

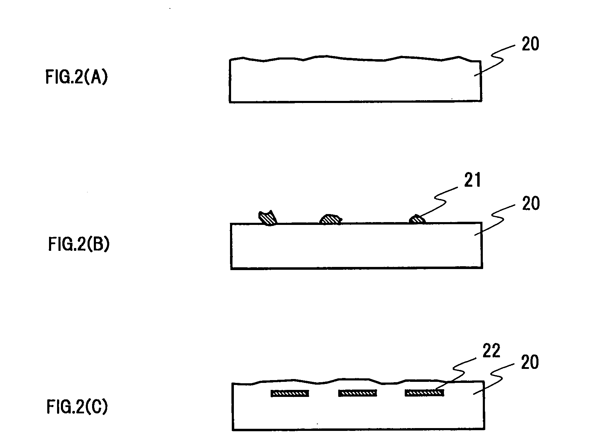

However, the bonding surface of the quartz substrate 20 is not an ideal perfect planar surface but is in a state of having microscopic roughness (Figure 2(A)) or in a state that a microparticle 21 or the like adheres to the bonding surface (Figure 2(B)) or there exists surface irregularity reflecting embedded patterns 22 previously provided in the bonding surface region of the quartz substrate (Figure 2(C)), as illustrated in Figure 2.

If the quartz substrate 20 having such a bonding surface as described above and the single-crystal silicon substrate 10 are bonded together, local "gaps" arise within the bonding surface, reflecting the surface irregularity or the like of the quartz substrate 20. As a result, there arises a region where strain is likely to concentrate locally. In the case of a conventional method, a relatively high-temperature heat treatment is applied in a "full bonding" step intended to increase bonding strength, and the atomic rearrangement of Si and O occurs locally in a bonded surface between the quartz substrate 20 and the oxide film 11 during this heat treatment step. Thus, the strain concentration tends to be relaxed.

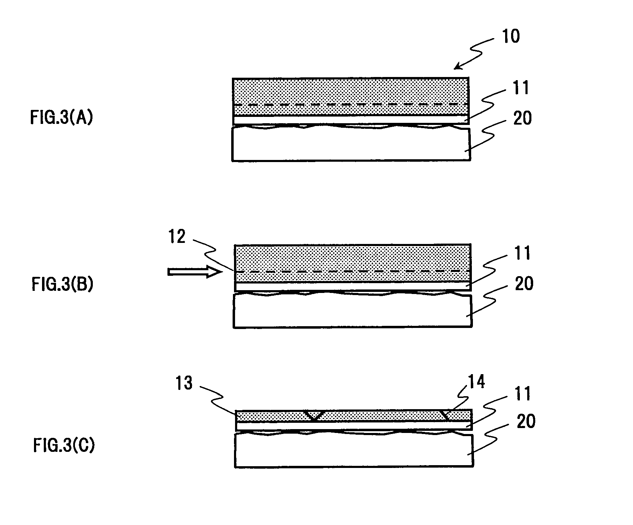

However, in the case of fabricating an SOQ substrate using a consistent low-temperature process as in the present invention, such thermal energy for causing local strain relaxation based on atomic rearrangement as described above is not provided from the outside. Accordingly, if the single-crystal silicon substrate 10 and the quartz substrate 20 are bonded together (Figure 3(A)) and a silicon thin film is peeled off by, for example, applying impact from the outside (Figure 3(B)), there arises such a problem that defects, such as slip dislocation 14 or transfer failure, occur due to local strain concentration reflecting the surface irregularity or the like of the quartz substrate 20 (Figure 3(C)).

In a method for manufacturing an SOI substrate according to the present invention, a low-temperature process is employed in order to prevent the occurrence of thermal strain (thermal stress) attributable to a difference in thermal expansion coefficient between the silicon substrate and the quartz substrate. Therefore, the method does not use such a relatively high-temperature heat treatment for the purpose of increasing the bonding strength of the two substrates as used in the conventional method. Alternatively, the method sets the thickness "tₒₓ" of the oxide film 11 to not less than 0.2 µm to allow a thin film peeled off from the single-crystal silicon substrate side to have sufficient mechanical strength and allows the relatively thick oxide film to absorb and relax the strain, thereby preventing the occurrence of transfer defects during a separation step.

The main reason for setting the thickness "tₒₓ" of the oxide film 11 to not less than 0.2 µm in the present invention is to increase mechanical strength by increasing the total thickness of a thin film peeled off from the single-crystal silicon substrate side (i.e., the oxide film and the silicon thin film) and to allow the oxide film absorb and relax strain, thereby preventing the occurrence of "transfer defects" in a separation step. Note that the 0.2 µm or greater thickness of the oxide film selected in the present invention is a value obtained empirically as being effective in preventing transfer defects, slip dislocation and the like arising from a boundary face from reaching the silicon thin film.

The mechanical strength of a thin film peeled off from the single-crystal silicon substrate side when peeling off and transfer a silicon thin film onto the quartz substrate depends on the sum of the thickness "t_{Si}" (= L) of the silicon thin film and thickness "tₒₓ" of the oxide film. Consequently, it is possible to more effectively prevent the occurrence of "transfer defects," such as voids, in a separation step with the increase of the total thickness ("t_{Si}" + "tₒₓ") of the silicon thin film and the oxide film.

If, for example, particles interpose between the oxide film 11 and the bonding surface of the quartz substrate 20 in a case where the thickness of the oxide film 11 is as small as approximately 0.1 µm and a local "gap" occurs within the bonding surface, transfer defects or slip dislocation easily occurs with the gap region as a point of origin, since strain tends to concentrate locally in the gap region. In a case, however, where the thickness of the oxide film 11 is set to not less than 0.2 µm, the strain is relaxed within the oxide film 11 and, therefore, stress loading upon a silicon thin film (SOI layer) provided on the oxide film is reduced.

In the case of an SOI substrate in which a pair of silicon substrates is selected as substrates to be bonded together, the thickness of an oxide film to be serving as an SOI layer is generally specified as approximately 0.1 µm. In the case of an SOQ substrate, however, no disadvantages arise even if an oxide film provided on one principal surface of a single-crystal silicon substrate and formed of Si-O bonds is as thick as 0.2 µm or greater, since a quartz substrate formed of Si-O bonds is used as a handling substrate. Note that for such an oxide film 11 as described above, it is possible to easily obtain a high-quality thin film by thermally oxidizing a surface of the single-crystal silicon substrate.

In addition, according to experiments conducted by the present inventor et al., there was obtained the result that it was possible to effectively prevent defect generation during a separation step also in a case where a film thickness selection was made so that the thickness (tₒₓ) of the oxide film 11 to be provided on the single-crystal silicon substrate was equal to or greater than twice the thickness (i.e., either L or "t_{Si}") of an SOI layer (2L ≤ tₒₓ). Also in this case, it is considered that strain caused locally within the bonding surface is relaxed by the oxide film as thick as not less than twice the thickness of the SOI layer (2L ≤ tₒₓ) and, therefore, stress loading upon a silicon thin film (SOI layer) provided on the oxide film is reduced.

Accordingly, as the single-crystal silicon substrate to be bonded to the quartz substrate, there may be used a substrate which satisfies the relationship 2L ≤ tₒₓ between the thickness (tₒₓ) of the oxide film and the average ion implantation depth L of the hydrogen ion-implanted layer.

Hereinafter, a method for manufacturing an SOI substrate according to the present invention will be described with reference to embodiments thereof.

### Embodiments

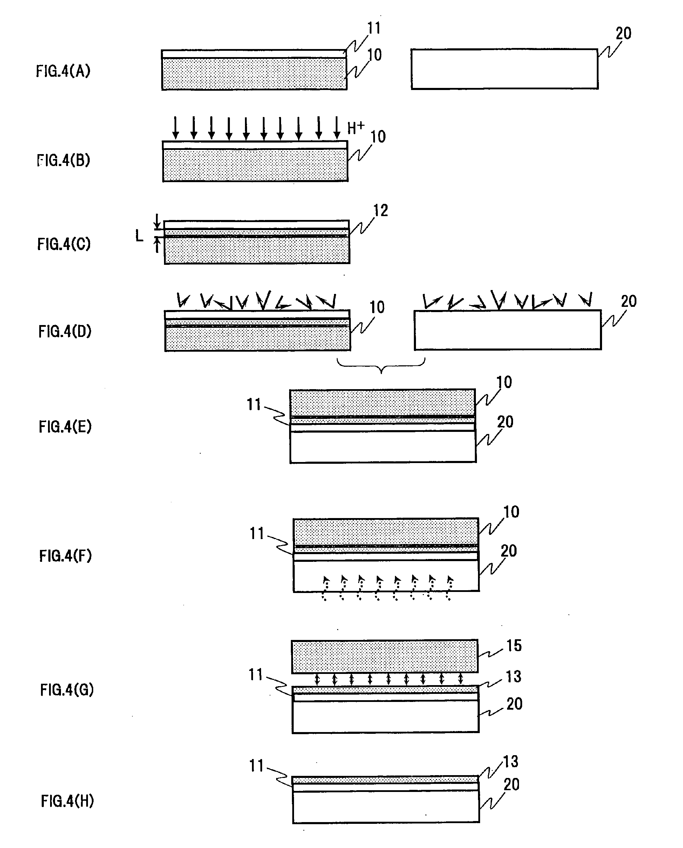

Figure 4 is a schematic view used to explain a process example of a method for manufacturing an SOI substrate according to the present invention, wherein a first substrate 10 illustrated in Figure 4(A) is a single-crystal Si substrate and a second substrate 20 is a quartz substrate. Here, the single-crystal Si substrate 10 is, for example, a commercially-available Si substrate grown by the Czochralski (CZ) method. The electrical property values, such as the conductivity type and specific resistivity, the crystal orientation and the crystal diameter of the single-crystal Si substrate 10 are selected as appropriate depending on the design value and process of a device to which the SOI substrate manufactured using the method of the present invention is devoted or on the display area of a device to be manufactured. Note that, as described above, an oxide film 11 is previously formed by means of, for example, thermal oxidation on a surface (bonding surface) of this single-crystal Si substrate 10.

Also note that there is also a case where embedded patterns are previously formed on the bonding surface side of the quartz substrate 20, as illustrated in Figure 2(C). Such embedded patterns are, for example, of a type having a step equal to or greater than 0.03 µm. After forming such patterns as described above on a surface of the quartz substrate, a quartz material is film-formed by a CVD method or a sputtering method so as to cover these patterns. Then, a polishing treatment is applied to the surface of the quartz substrate, thereby finishing the surface as the bonding surface.

The diameters of the single-crystal silicon substrate 10 and the quartz substrate 20 to be bonded together are the same. For the sake of convenience in a subsequent device formation process, it is advantageous to provide the same orientation flat (OF) as the OF provided in the single-crystal Si substrate 10 also in the quartz substrate 20, and bond the substrates together by aligning these OFs with each other.

First, hydrogen ions are implanted into a surface of the first substrate (single-crystal Si substrate) 10, to form a hydrogen ion-implanted layer 12 (Figure 4(B)). This ion-implanted surface serves as a later-discussed "bonding surface (joint surface)". As the result of this hydrogen ion implantation, a uniform ion-implanted layer 12 is formed near a surface of the single-crystal Si substrate 10 at a predetermined depth (average ion implantation depth L). In a region at a depth corresponding to the average ion implantation depth L in a surface region of the single-crystal Si substrate 10, there is formed a "microbubble layer" which exists locally in the aforementioned region (Figure 4(C)).

For a dose amount at the time of hydrogen ion implantation, an appropriate value in the range, for example, from 1 × 10¹⁶ to 4 × 10¹⁷ atoms/cm² is selected according to the specifications of an SOQ substrate and the like. Note that, the surface roughness of an SOI layer to be subsequently obtained is supposed to occur if the dose amount of hydrogen ions exceeds 1 × 10¹⁷ atoms/cm² when fabricating an SOI substrate using the SmartCut method. Hence, the dose amount is generally set to approximately 7 × 10¹⁶ atoms/cm².

According to a study made by the present inventor et al., however, it has become evident that the surface roughness of an SOI layer supposed to occur in a conventional method under the above-described ion implantation conditions is attributable not to the dose amount of hydrogen ions itself but to a step of relatively high-temperature (e.g., 500°C) heat treatment employed in order to obtain the SOI layer by peeling off a silicon thin film.

As described above, when fabricating the SOI substrate using the SmartCut method, hydrogen ions are implanted into the bonding surface side of the silicon substrate to generate "gas bubbles" called a "microbubble layer" at a high density, and a silicon thin film is thermally peeled off by taking advantage of the "bubble growth" of the "microbubble layer" produced due to a relatively high-temperature heat treatment. Note here that since the "bubble growth" is nothing else but the diffusion phenomenon of hydrogen atoms, the diffusion of hydrogen atoms is taking place noticeably in the process of "growth" of extremely high-density "gas bubbles" to be formed under a high-dose condition. Thus, it is possible to understand that such an atomic diffusion phenomenon causes the surface roughness of an SOI layer.

Accordingly, when peeling off a silicon thin film at low temperatures as in the present invention, there is no possibility of causing the surface roughness of an SOI layer even if a high dose amount of hydrogen ions is implanted, since the diffusion of hydrogen atoms during the peel-off treatment step is significantly suppressed. The present inventor et al. investigated effects on the surface roughness of an SOI layer by applying hydrogen ion implantation at various dose amounts. As a result, no surface roughness was observed for a dose amount of up to at least 4 × 10¹⁷ atoms/cm², as long as silicon thin film separation was carried out using a low-temperature heat treatment of approximately 300°C at the highest.

The depth (average ion implantation depth L) of the ion-implanted layer 12 from the surface of the single-crystal Si substrate 10 (boundary face abutting the oxide film 11) is controlled by an acceleration voltage at the time of ion implantation and is determined depending on how thick an SOI layer to be peeled off is. For example, the average ion implantation depth L is set to 0.5 µm or less and the acceleration voltage is set to 50 to 100 KeV. Note that an insulating film, such as an oxide film, may be previously formed on the ion-implanted surface of the single-crystal Si substrate 10 and ion implantation may be applied through this insulating film in a process of ion implantation into Si crystal, as is commonly practiced to suppress the channeling of implanted ions.

A plasma treatment or an ozone treatment for the purpose of surface cleaning, surface activation and the like is applied to the respective bonding surfaces of the single-crystal Si substrate 10 in which the ion-implanted layer 12 has been formed and the quartz substrate 20 (Figure 4(D)). Note that such a surface treatment as described above is performed for the purpose of removing organic matter from a surface serving as a bonding surface or achieving surface activation by increasing surface OH groups. However, the surface treatment need not necessarily be applied to both of the bonding surfaces of the single-crystal Si substrate 10 and the quartz substrate 20. Rather, the surface treatment may be applied to either one of the two bonding surfaces.

When carrying out this surface treatment by means of plasma treatment, a surface-cleaned single-crystal Si substrate to which RCA cleaning or the like has been applied previously and/or a quartz substrate is mounted on a sample stage within a vacuum chamber, and a gas for plasma is introduced into the vacuum chamber so that a predetermined degree of vacuum is reached. Note that examples of gas species for plasma used here include an oxygen gas, a hydrogen gas, an argon gas, a mixed gas thereof, or a mixed gas of hydrogen and helium. High-frequency plasma having an electrical power of approximately 100 W is generated after the introduction of the gas for plasma, thereby applying the surface treatment for approximately 5 to 10 seconds to a surface of the single-crystal Si substrate and/or a surface of the quartz substrate to be plasma-treated, and then finishing the surface treatment.

When the surface treatment is carried out by means of ozone treatment, a surface-cleaned single-crystal Si substrate and/or a quartz substrate is mounted on a sample stage within a chamber placed in an oxygen-containing atmosphere. Then, after introducing a gas for plasma, such as a nitrogen gas or an argon gas, into the chamber, high-frequency plasma having a predetermined electrical power is generated to convert oxygen in the atmosphere into ozone by the plasma. Thus, a surface treatment is applied for a predetermined length of time to a surface of the single-crystal Si substrate and/or a surface of the quartz substrate to be treated.

The single-crystal Si substrate 10 and the quartz substrate 20, to which such a surface treatment as described above has been applied, are bonded together with the surfaces thereof closely adhered to each other as bonding surfaces (Figure 4(E)). As described above, the surface (bonding surface) of at least one of the single-crystal Si substrate 10 and the quartz substrate 20 has been subjected to a surface treatment by plasma treatment, ozone treatment or the like and is therefore in an activated state. Thus, it is possible to obtain a level of bonding strength fully resistant to mechanical separation or mechanical polishing in a post-process even if the substrates are closely adhered to each other (bonded together) at room temperature.

Note that there may be provided a sub-step of heat-treating the single-crystal silicon substrate 10 and the quartz substrate 20 at 100 to 300°C with the substrates bonded together, in succession to the bonding step illustrated in Figure 4(E) (Figure 4(F)). The primary purpose of this heat treatment step is to obtain the effect of increasing the bonding strength between the oxide film 11 formed on the single-crystal silicon substrate 10 and the quartz substrate 20.

The main reason for this heat treatment temperature being set to not higher than 350°C is because consideration is given to a difference in thermal expansion coefficient between single-crystal silicon and quartz, an amount of strain attributable to the thermal expansion coefficient difference, and a relationship between the amount of strain and the thicknesses of the single crystal silicon substrate 10 and the quartz substrate 20. If the thicknesses of the single-crystal silicon substrate 10 and the quartz substrate 20 are almost the same with each other, thermal strain-induced cracks or separation at a bonding plane occurs due to a difference in rigidity between the two substrates when the substrates are subjected to a heat treatment at a temperature higher than 320 to 350°C, since there is a significant difference between the thermal expansion coefficient (2.33 × 10⁻⁶) of single-crystal silicon and the thermal expansion coefficient (0.6 × 10⁻⁶) of quartz. In an extreme case, the breakage of the single-crystal silicon substrate or the quartz substrate occurs. From this point of view, the upper limit of the heat treatment temperature is specified as 300°C.

Note that depending on the dose amount of hydrogen ions, there can also be expected from this heat treatment the secondary effect of generating thermal stress due to a thermal expansion coefficient difference between the silicon substrate 10 and the quartz substrate 20, thereby weakening the chemical bonding of silicon atoms within the ion-implanted layer 12.

If the ion implantation illustrated in Figure 4(B) is carried out at a relatively high dose amount of 8 × 10¹⁶ to 4 × 10¹⁷ atoms/cm², Si atoms having Si-H bonds and unpaired bonds are present at a high density within the ion-implanted layer 12. Accordingly, if a heat treatment is applied with the substrates bonded together, a large stress is generated between the bonded substrates across the entire bonded surface thereof because silicon crystal has a thermal expansion coefficient larger than that of quartz.

Si atoms having unpaired bonds and high-density "Si-H bonds" are present in a "microbubble layer" which exists locally in a region of the ion-implanted layer 12 at a depth corresponding to the average ion implantation depth L and, therefore, the state of atomic binding is locally weakened. Consequently, if the aforementioned stress attributable to a thermal expansion coefficient difference between the substrates is applied to the ion-implanted layer 12 in this state, inherently fragile chemical bonds are easily broken. Thus, the chemical bonding of silicon atoms within the ion-implanted layer 12 is significantly weakened. In addition, a temperature of not higher than 300°C is such a low temperature that the diffusion of hydrogen atoms within silicon crystal does not takes place noticeably. Therefore, the surface roughness of an SOI layer, which has been a problem in conventional methods, does not occur.

In succession to such a treatment as described above, a silicon thin film 13 is peeled off from a single crystal silicon bulk 15 by applying external impact to the bonded substrate using a certain technique (Figure 4(G)), thereby obtaining an SOI layer 13 which is provided on the quartz substrate 20 through the oxide film 11 (Figure 4(H)).

Note that there can be various ways of externally applying impact in order to peel off a silicon thin film.

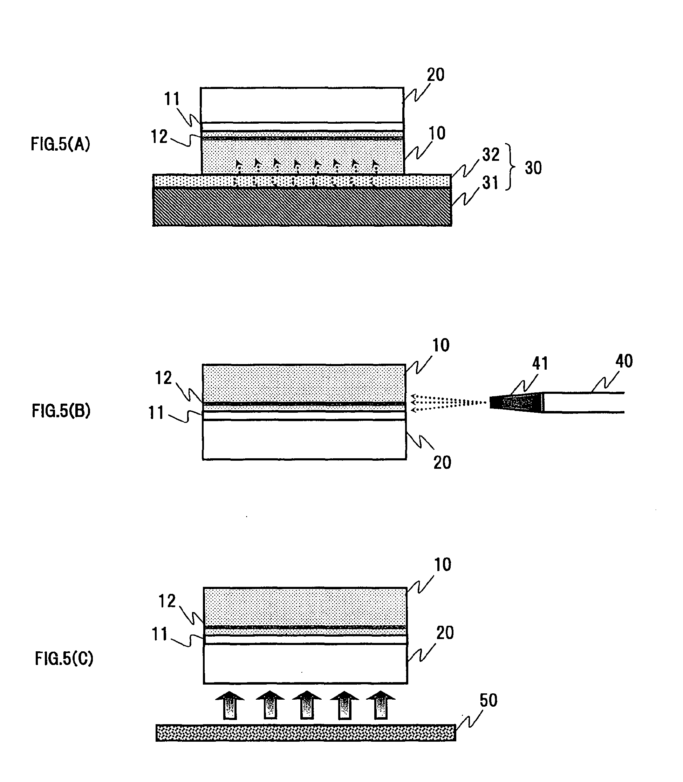

Figure 5 is a conceptual schematic view used to explain various techniques for peeling off a silicon thin film, wherein Figure 5(A) illustrates an example of performing separation by thermal shock, Figure 5(B) illustrates an example of performing separation by mechanical shock, and Figure 5(C) illustrates an example of performing separation by vibratory shock.

In Figure 5(A), reference numeral 30 denotes a heating section. In this figure, a heating plate 32 having a smooth surface is placed on a hot plate 31, and the smooth surface of this heating plate 32 is closely adhered on the rear surface of the single-crystal Si substrate 10 bonded to the quartz substrate 20. Although a dummy silicon substrate is used here as the heating plate 32, there are no particular restrictions on the material of the heating plate as long as a smooth surface is available (semiconductor substrate or ceramic substrate).

Silicone rubber or the like can also be used as the heating plate material, though not suited for use at temperatures above 250°C since the allowable temperature limit of the rubber is considered to be approximately 250°C. The heating plate 32 need not be used in particular, as long as the surface of the hot plate 31 is sufficiently smooth. Alternatively, the hot plate 31 itself may be used as the "heating plate".

When the temperature of the heating plate 32 is kept at, for example, 300°C and the rear surface of the single-crystal Si substrate 10 bonded to the quartz substrate 20 is closely adhered on this heating plate 32, the single-crystal Si substrate 10 is heated by thermal conduction, thereby generating a temperature difference between the Si substrate and the quartz substrate 20. As described above, since the thermal expansion coefficient of the silicon substrate is larger than the thermal expansion coefficient of the quartz substrate, a large stress is generated between the two substrates due to the rapid expansion of the single-crystal Si substrate 10 if the single-crystal Si substrate 10 in a bonded state is heated from the rear surface thereof. The separation of a silicon thin film is caused by this stress.

The example illustrated in Figure 5(B) utilizes a jet of a fluid to apply mechanical shock. That is, a fluid, such as a gas or a liquid, is sprayed in a jet-like manner from the leading end 41 of a nozzle 40 at a side surface of the single-crystal Si substrate 10, thereby applying impact. An alternative technique, for example, is to apply impact by pressing the leading end of a blade against a region near the ion-implanted layer 12.

Yet alternatively, as illustrated in Figure 5(C), the separation of a silicon thin film may be caused by applying vibratory shock using ultrasonic waves emitted from the vibrating plate 50 of an ultrasonic oscillator.

Evaluation of the surface condition of an SOI substrate obtained by following such a series of processes as described above showed that there were neither defects, such as the local separation of a silicon thin film, traces of separation and untransferred regions, nor the occurrence of slip dislocation. Thus, the substrate surface exhibited an extremely planar state. Measurement of a 10 µm × 10 µm area of the surface of the SOI layer after separation using an atomic force microscope (AFM) showed that the RMS mean value was as excellent as no greater than 5 nm. In addition, the film-thickness variation (PV: peak-to-valley) of the SOI layer within the substrate surface was no larger than 4 nm.

As described above, in the present invention, it is possible to consistently carry out processing at low temperatures (not higher than 300°C). It is therefore possible to provide an SOQ substrate having an SOI layer superior in film uniformity, crystal quality and electrical characteristics (carrier mobility and the like). In addition, the present invention is extremely advantageous from the viewpoint of stabilizing and simplifying the manufacturing process of an SOQ substrate. Industrial Applicability

According to the present invention, there is provided a technique to avoid causing any transfer defects or slip dislocation in a subsequent separation step even if the bonding together of a single-crystal silicon substrate and a quartz substrate is performed using a low-temperature process when manufacturing an SOI substrate (SOQ substrate) by bonding together the single-crystal silicon substrate and the quartz substrate. Consequently, it is possible to increase a yield in a step of silicon thin film separation and improve the surface condition of an SOI layer obtained by separation.

As a result, it is possible to provide an SOQ substrate having an SOI layer superior in film uniformity, crystal quality, and electrical characteristics (carrier mobility and the like).

## Claims

1. An SOI substrate **characterized in that** an SOI layer formed of a silicon thin film bonded through a silicon dioxide film having a thickness of not less than 0.2 µm is provided on a quartz substrate which is a transparent insulating substrate.

2. An SOI substrate **characterized in that** an SOI layer formed of a silicon thin film bonded through a silicon dioxide film is provided on a quartz substrate which is a transparent insulating substrate and the thickness of said oxide film is equal to or greater than twice the thickness of said SOI layer.

3. The SOI substrate according to claim 1 or 2, **characterized in that** said oxide film is a thermally-oxidized film of said single-crystal silicon substrate.

4. The SOI substrate according to any one of claims 1 to 3, **characterized in that** said quartz substrate includes an embedded pattern on the bonding surface side thereof.

5. A method for manufacturing an SOI substrate, **characterized by** comprising:
a first step of forming a silicon dioxide film having a thickness of not less than 0.2 µm on a surface of a first substrate which is a single-crystal silicon substrate;
a second step of forming an ion-implanted layer in said first substrate by implanting hydrogen ions therein through said oxide film;
a third step of applying a surface activation treatment to the bonding surface of at least one of a second substrate which is a quartz substrate and said first substrate;
a fourth step of bonding together the surface of said first substrate and the surface of said second substrate; and
a fifth step of forming an SOI layer on the surface of said second substrate by peeling off a silicon thin film from said first substrate of the bonded substrate provided after said heat treatment.

6. A method for manufacturing an SOI substrate, **characterized by** comprising:
a first step of forming a silicon dioxide film having a thickness of "tₒₓ" on a surface of a first substrate which is a single-crystal silicon substrate;
a second step of forming an ion-implanted layer having an average ion implantation depth L equal to or less than half the thickness of said oxide film (2L ≤ tₒₓ) in said first substrate by implanting hydrogen ions therein through said oxide film;
a third step of applying a surface activation treatment to the bonding surface of at least one of a second substrate which is a quartz substrate and said first substrate;
a fourth step of bonding together the surface of said first substrate and the surface of said second substrate; and
a fifth step of forming an SOI layer on the surface of said second substrate by peeling off a silicon thin film from said first substrate of the bonded substrate provided after said heat treatment.

7. The method for manufacturing an SOI substrate according to claim 5 or 6, **characterized in that** said third step of surface activation treatment is carried out by means of at least one of plasma treatment and ozone treatment.

8. The method for manufacturing an SOI substrate according to any one of claims 5 to 7, **characterized in that** said fourth step includes a sub-step of heat-treating said first substrate and said second substrate at 100 to 300°C after said bonding together, with said first and second substrates bonded together.

9. The method for manufacturing an SOI substrate according to any one of claims 5 to 8, **characterized in that** said first step of oxide film formation is carried out by thermally oxidizing the surface of said single-crystal silicon substrate

10. The method for manufacturing an SOI substrate according to any one of claims 5 to 9, **characterized in that** said third step includes a sub-step of previously forming an embedded pattern on the bonding surface side of said quartz substrate.
